Europäisches Patentamt

European Patent Office

Office européen des brevets

(19)

(11) Publication number: **0 408 240 A2**

# EUROPEAN PATENT APPLICATION

(21) Application number: 90307308.8

(22) Date of filing: 04.07.90

(51) Int. Cl.⁵: **H01L 39/24**

(30) Priority: 11.07.89 US 379497

(43) Date of publication of application:
16.01.91 Bulletin 91/03

(84) Designated Contracting States:
AT BE DE FR GB IT NL SE

(71) Applicant: **GENERAL ATOMICS**
**10955 John Jay Hopkins Drive**
**San Diego California 92121-1194(US)**

(72) Inventor: **Liang, Samuel Shu-Kiang**
**4644 Benhurst Avenue**
**San Diego, California 92112(US)**
Inventor: **Woolf, Lawrence D.**
**7920 Corte Cardo**
**Carlsbad, California 92009(US)**
Inventor: **Chin, Jack**
**2437 Unicornio Street**
**Carlsbad, California 92009(US)**

(74) Representative: **Coxon, Philip et al**
**Eric Potter & Clarkson St. Mary's Court St.**
**Mary's Gateate**
**Nottingham NG1 1LE(GB)**

(54) Flash evaporation method for producing superconductor powder.

(57) An apparatus and method for preparing particles of superconductor material includes a container for holding a prepared solution of barium, copper and a rare earth element dissolved in nitric acid. A nozzle is provided to release an aerosol spray of the solution onto the smooth surface of a preheated plate. Contact of the sprayed solution with the hot surface evaporates the sprayed solution to vaporise water in the solution and form an atomically mixed, homogeneous precipitate. A scraper is provided to remove the precipitate from the surface of the plate, and this precipitate is then denitrated and then calcined in a furnace.

Fig. 2

The present invention pertains to apparatus and methods which are useful for the manufacture of superconductor materials. The present invention relates to apparatus and methods for preparing particles of superconductor material. More particularly, the present invention pertains to the preparation of particles of superconductor material from constituents which are initially atomically mixed and held in solution. The present invention is particularly, but not exclusively, useful for drying aerosol sprays to manufacture homogeneous powders of superconducting material.

Several methods have been proposed for the preparation of superconductor materials. Typically, the initial step in preparing such materials is to dissolve superconductor constituents in a solution. Then, the problem is to transform the material from the solution into a dry state in which it is as homogeneous (i.e. atomically mixed) as it was in the liquid state. Further, it is desirable that the precipitate be phase pure and, accordingly, have few, if any, eutectics.

One known method for drying superconductor material from a solution is the process generally referred to as gas phase precipitation or spray pyrolysis. For this process, a solution of superconductor material is sprayed into a furnace and allowed to dehydrate and possibly react as it falls through the furnace. The resultant precipitate is then collected from the furnace and may be further processed to create superconductor particles. Spray pyrolysis, however, presents certain difficulties. First, it can be difficult to collect the fine particles from the furnace. Further, due to convection currents in the furnace and the difficulty in precisely directing the spray into the furnace, the furnace side walls are easily contaminated and the precipitate tends to agglomerate there. Thus, not all of the powder that is produced is collected. Also, the slow dehydration which occurs in this process may lead to segregation of the various components in each drop, leading to inhomogeneities in the final powder product. An example of this particular procedure is set forth in "Aerosol Flow Reactor Production of Fine $Y_1Ba_2Cu_3O_7$ Powder: Fabrication of Superconducting Ceramics", T.T. Kodas et al., Applied Physics Letters, 52 , 1622 (1988).

Another known method for precipitating superconductor material from solution is the process wherein a heated plate is rotated and the solution is released onto the plate from its centre. This causes the solution to be spun onto the heated surface of the plate to create a thin film or layer of precipitate as the water in solution evaporates. Due to agitation and relatively slow evaporation, however, this spinning method also tends toward agglomeration and the formation of a non-homogeneous precipitate. It is difficult to scale-up this process to produce large quantities of powder. An example of this procedure is set forth in "Government, Industry Back U.K. Superconductor Effort", Ceramic Industry , April 1989, p. 81.

A more conventional method for precipitating superconductor material from a prepared solution is the well known process involving liquid state precipitation. The major problem with a liquid state precipitation process, however, is the difficulty in achieving homogeneous precipitation. Thus, it is typically necessary to take the time and effort to adjust the composition and pH of the solution in order to obtain satisfactory results. Additionally, even after precipitation has occurred, it can be difficult to separate the precipitate from the solution for further processing. An example of this procedure is set forth in "Comparison of Carbonate, Citrate and Oxalate Chemical Routes to the High $T_c$ Metal Oxide Superconductors $La_{2-x}Sr_xCuO_4$", H.H.Wang et al., Inorganic Chemistry 26 , 1476 (1987).

It is an object of the invention to provide an improved apparatus and method for preparing particles of superconductor material.

According to one aspect of this invention there is provided an apparatus for preparing particles of superconductor material which comprises:
means for holding a substantially stoichiometric solution;
means in fluid communication with said holding means for spraying said solution; and
means for receiving said sprayed solution to evaporate said solution and form a precipitate.

According to another aspect of this invention there is provided an apparatus for preparing particles of superconductor material which comprises:
a container for holding a substantially stoichiometric solution;
a plate heatable to a predetermined temperature; and
a nozzle in fluid communication with said container for spraying said solution onto said plate to evaporate said solution and form a precipitate of superconductor material.

According to another aspect of this invention there is provided an apparatus for preparing particles of superconductor material which comprises:
means for holding a stoichiometric nitric acid solution;
means in fluid communication with said holding means for spraying said solution;
means for receiving said sprayed solution to evaporate said solution and form a precipitate therefrom;
means associated with said evaporating means for removing said precipitate from said evaporating means; and

means connected with said evaporating means for receiving said removed precipitate and calcining said precipitate.

According to another aspect of this invention there is provided a method for preparing particles of super-conductor material which comprises the steps of:

preparing a substantially stoichiometric nitric acid solution;

spraying said solution onto the smooth surface of a plate;

preheating said surface of said plate to evaporate said solution sprayed thereon, and to form a precipitate thereof;

removing said precipitate from said plate;

partially decomposing residual nitrates in said precipitate; and

calcining said precipitate.

Thus, the present invention recognises that several shortcomings of the prior art can be overcome by an apparatus and method which rapidly evaporates water from a prepared superconductor solution. Further, the present invention recognises that sufficiently rapid evaporation can be accomplished when an aerosol of the solution is sprayed directly onto a heated surface where each droplet is individually vaporised.

An apparatus for preparing a powder of superconductor materials may include a container for holding a solution of superconductor constituents. Specifically, a homogeneous, atomically mixed solution may be prepared by dissolving a rare earth barium and copper (e.g. $RE_2O_3$, where RE is yttrium or a rare earth element, CuO and $Ba(NO_3)_2$) in nitric acid and water. The combination of these elements stoichiometrically, or slightly off-stoichiometrically (e.g. $Dy_{1.05}$ - $Ba_{1.95}$ - $Cu_{2.90}$), results in a solution containing atomically mixed superconductor material.

The apparatus of the present invention may also include a plate which may have a smooth flat surface that is resistant to thermal shock. Also, the plate may be made of a material which is not chemically reactive with the solution below six hundred degrees centigrade (600°C), or its constituents, and which can effectively handle temperatures up to approximately six hundred degrees centigrade (600°C).

Preferably a nozzle is provided which may be connected in fluid communication with the solution in the container to spray the solution onto the surface of the plate. More preferably, the nozzle is made of a material which is not reactive with the solution, e.g. glass or titanium. Further, the nozzle is preferably capable of producing an atomized spray of the solution which comprises droplets that are approximately equal to or less than fifty (50) microns in diameter. By preheating the surface of the plate to approximately two hundred degrees centigrade (200°C) the sprayed solution is rapidly heated when it contacts the surface. This heating quickly vaporises the water in the solution and forms a homogeneous solid precipitate which is deposited on the surface.

A scraper may be used to remove the precipitate from the surface. The scraper is preferably engageable with the plate. The precipitate may then be placed on another plate and heated to approximately five hundred degrees centigrade (500°C) to decompose most of the nitrates in the precipitate and remove any remaining waters of hydration. Next, the precipitated superconductor material may be placed in a furnace and calcined for approximately one (1) to eight (8) hours at temperatures in the range of eight hundred to nine hundred twenty-five degrees centigrade (800°C - 925°C). If desired the material can be ground after it has been calcined to expose new surfaces and then recalcined at the elevated temperatures in the range of eight hundred to nine hundred twenty-five degrees centigrade (800°C -925°C for a period of time somewhere between one (1) and eight (8) hours. Oxygenation of the superconductor material may be accomplished by slowly cooling the material from the calcining temperatures and holding the temperature constant at an intermediate level of approximately four hundred degrees centigrade (400°C) before further cooling the material to room temperature.

In light of the above, it is an advantage of the present invention that it provides an apparatus and a method for the preparation of a superconductor which creates a precipitate that is as homogeneous in the dry state as it was in the liquid state. Another advantage of the present invention is that it provides an apparatus and a method for the preparation of a superconductor which creates a precipitate that is phase pure and contains no observable eutectics. Still another advantage of the present invention is that it provides an apparatus and a method for the preparation of a superconductor which creates fine particles of superconductor material. Yet another advantage of the present invention is that it provides an apparatus for the preparation of a superconductor which is easy to use. Still another advantage of the present invention is that it provides a method for the preparation of a superconductor which quickly and reproducibly creates the superconductor particles. Another advantage of the present invention is that it provides an apparatus and a method for the preparation of a superconductor which is applicable to all stoichio metries without the need to adjust the composition and pH of a solution. Still another advantage of the present invention is that it provides an apparatus and a method for the preparation of a superconductor which is simple, compact, and comparatively cost-effective.

Reference is now made to the accompanying drawings in which:

Figure 1 is a block diagram showing the sequential steps used in preparing particles of superconducting material according to the present invention; and

Figure 2 is a schematic diagram of the components used to perform the steps set forth in Figure 1.

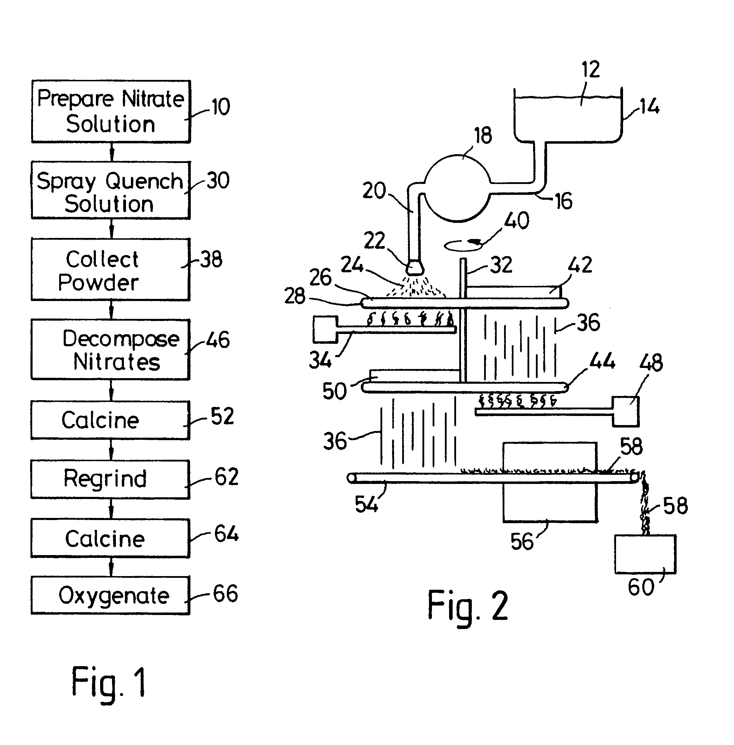

Referring initially to Figure 1, a block diagram is presented which sequentially identifies the various steps which are followed for the preparation of superconductor powder according to the present invention. Block lu in Figure 1 indicates that the first step involves preparation of a nitrate solution. This solution, which is designated 12 in Figure 2, is preferably prepared by dissolving selected ingredients in nitric acid and water to form a stoichiometric mixture. Specifically, twenty- eight and seven tenths (28.7) grams of $Dy_2O_3$, thirty-six and seven tenths (36.7) grams of CuO, and eighty and four tenths (80.4) grams of $Ba(NO_3)_2$ are dissolved in nitric acid and water. Although $Dy_2O_3$ is cited here in the preferred embodiment, this process is generally applicable to all high temperature superconducting materials. Thus, other rare earth or yttrium oxides could also be used.

Although a stoichiometric mixture is desired, it has been found that by mixing the constituents slightly off stoichiometry, a precipitate may result which includes fewer eutectics or which may include additional second phases that aid in flux pinning in the final superconductor product. Consequently, liquid phases are minimised. Specifically, for this purpose, it is preferred that the composition $Dy_{1.05}Ba_{1.95}Cu_{2.90}O_7$ be used. In any event, the result is a composition of the popularly so-called 1-2-3 superconductor.

As shown in Figure 2, the solution 12 is held in a container 14 which is connected in fluid communication via pipe 16 with a pump 18. Activation of pump 18 forces solution 12 through pipe 20 and out of a nozzle 22. Importantly, nozzle 22 should be made of a material which is chemically nonreactive with solution 12. For example, the nozzle 22 can be made of Pyrex glass or titanium. Further, it is important that nozzle 22 be capable of producing an aerosol 24 which comprises droplets of solution 12 which are on the order of ten (10) to one hundred (100) microns in diameter. This aerosol 24 is sprayed from nozzle 22 directly onto a surface 26 of the plate 28. For purposes of the present invention, nozzle 22 can be either an atomizer of any type well known in the pertinent art, or an ultrasonic nozzle of a type such as is manufactured by Sono-Tek.

In order to control aerosol 24 (i.e. the sprayed solution) and achieve appropriate dispersion of the sprayed solution 12, nozzle 22 is positioned in relatively near proximity to the surface 26 of plate 28. Preferably, this distance is on the order of approximately six (6) inches. Contact of the aerosol 24 which surface 26 accomplishes the the next step of the process which is indicated by block 30 in Figure 1. Namely, the aerosol 24 is flash evaporated, that is, the liquid droplets are rapidly dried when they contact the surface of the hot plate.

Figure 2 indicates that plate 28 is mounted on a base 32. Preferably, base 32 is a structure, such as the rod shown, which will permit rotation of the plate 28. Also, a heater 34 is provided and is positioned to heat plate 28. As contemplated by the present invention, heater 34 preferably heats surface 26 of plate 28 to temperatures in the range of one hundred eighty degrees centigrade (180° C) to two hundred thirty degrees centigrade (230° C). With surface 26 in this temperature range, aerosol 24 will vaporise upon contact with the surface 26 to create a precipitate 36. In order for plate 28 to function properly during this flash evaporation step, it is necessary for the plate 26 to have certain characteristics. Specifically, plate 26 must be chemically nonreactive with solution 12. Additionally, plate 28 must be resistive to thermal shock so that it will not craze or crack during the flash evaporation step. Further, surface 26 of plate 28 should be smooth in order to facilitate removal of the precipitate 36 from surface 26. With this in mind, it is preferable that plate 28 be made of a glass ceramic material such as the commercially available product known as Pyroceram and manufactured by Corning.

At this stage of the process (i.e. aerosol 24 has been evaporated on surface 26 to create precipitate 36) the precipitate 36 is a substance adhering to the surface which includes a homogeneous mixture of rare earth nitrate, barium nitrate and copper nitrate. As indicated by block 38 in Figure 1, the next step in the process is to collect this substance as a powder.

Figure 2 indicates that plate 28 can be rotated about base 32 in a direction generally shown by arrow 40. Although plate 28 is shown only in side view in Figure 2, it is to be appreciated by the skilled artisan that plate 28 can be circular. Thus, rotation of plate 28 in a direction as indicated by arrow 40 will bring the precipitate 36 from aerosol 24 which has been deposited on surface 26 into contact with a scraper 42. Scraper 42 then removes the powder precipitate from surface 26 by pushing it through holes (not shown) which extend from surface 26 through plate 28. The precipitate 36 can then be collected or, as shown in Figure 2, be deposited on another plate 44. Preferably, scraper 42 is made of a material, such as Teflon or stainless steel, which is chemically nonreactive with the precipitate 36.

Block 46 of Figure 1 indicates that after the aerosol 24 of solution 12 has been flash evaporated, it will be necessary to decompose the residual nitrates. This can be done by heating precipitate 36 on plate 44 and a heater 48 is provided for this purpose. In order to properly decompose the majority of the residual nitrates in precipitate 36, it is necessary to elevate the temperature of the powder precipitate 36 into the temperature range of approximately four hundred to six hundred degrees centigrade (400°C - 600°C). The purpose of elevating precipitate 36 into this temperature range is really twofold. Not only will most of the nitrates be decomposed (though there may be some residual barium nitrate present), these elevated temperatures will also remove any remaining waters of hydration which may be present in the precipitate 36. Similar to the manner in which precipitate 36 was removed from plate 28, the rotation of plate 44 on base 32 in the direction indicated by arrow 40 will bring precipitate 36 into contact with a scraper 50. In all important respects, plate 44 is the same as plate 28 and scraper 50 is the same as scraper 42. Functionally, these components interact and operate similarly. In any event, precipitate 36 is removed from plate 44 for further processing.

As indicated by block 52 in Figure 1, after the nitrates in precipitate 36 have been decomposed and the waters of hydration have been removed, precipitate 36 is ready to be calcined. A conveyor belt 54, shown in Figure 2, can be used to transport precipitate 36 to a calciner 56. For the purposes of the present invention, calciner 56 may be either a conventional electric furnace or a rotary calciner. Indeed, calciner 56 may be of any type furnace well known in the pertinent art. In calciner 56, precipitate 36 is heated in the range of eight hundred to nine hundred twenty-five degrees centigrade (800°C -925°C) for approximately one (1) to eight (8) hours. This decomposes the remaining nitrates and forms the tetragonal structure typical of the 1-2-3 superconductor. The result is a powder of superconductor particles 58 which can be collected in container 60. During calcining, it is important to use a gas which is as substantially water ($H_2o$) and carbon dioxide ($CO_2$) free as is possible. Such gases could be $H_2O$ and $CO_2$ free in air or $H_2O$ and $CO_2$ free in oxygen. This is so in order to prevent the formation of barium carbonate from the superconductor material. Preferably, it may be desirable to calcine in ozonated air or oxygen, since ozone prevents the formation of barium carbonate better than can be realised with non-ozonated air or oxygen.

It may happen during the calcining step, that the particles 58 will agglomerate slightly and may still contain some residual nitrate components. It may be desirable to grind the particles 58 after they have been initially calcined to break up the agglomeration and expose new surfaces to be denitrated. In any event, after grinding, the superconductor particles 58 can be recalcined, as indicated by block 64 in Figure 1, at the original calcining temperatures for anywhere from one (1) to eight (8) hours.

As a final step in the process, block 66 of Figure 1 indicates an oxygenation process which is followed to fully oxygenate the superconductor particles 58 and transform the structure from the non-superconducting tetragonal phase to the superconducting orthorhombic phase. Specifically, during the last calcining, the particles 58 are slowly cooled from the calcining temperature of around eight hundred fifty degrees centigrade (850°C) to an intermediate temperature of about four hundred degrees centigrade (400°C). The particles 58 are held at this intermediate temperature for about four (4) hours and are then further cooled to room temperature. During slow cooling and oxygenating, it is important to use a gas which is as substantially water ($H_2O$) and carbon dioxide ($CO_2$) free as is possible. Such gases could be $H_2O$ and $CO_2$ free in air or $H_2O$ and $CO_2$ free in oxygen. This is so in order to prevent the formation of barium carbonate from the superconductor material. Preferably, it may be desirable to slow cool and oxygenate in ozonated air or oxygen, since ozone prevents the formation of barium carbonate better than can be realised with non-ozonated air or oxygen.

It will be appreciated by those skilled in the pertinent art that the present invention is applicable for the general manufacture of ceramic oxides. Accordingly, the present invention contemplates the preparation of ceramic powders other than the 1-2-3 superconductor. For example, a thallium (Tl), barium (Ba), calcium (Ca), and copper (Cu) oxide ceramic superconductor can be prepared in accordance with the present invention. Likewise, an oxide ceramic of bismuth (Bi), lead (Pb), calcium (Ca), strontium (Sr), and copper (Cu) can also be prepared.

While the particular flash evaporating method to produce ceramic superconducting powder as herein shown and disclosed in detail is fully capable of obtaining the objects and providing the advantages herein before stated, it is to be understood that it is merely illustrative of the presently preferred embodiments of the invention and that no limitations are intended to the details of construction or design herein shown other than as defined in the appended claims.

## Claims

1. An apparatus for preparing particles of superconductor material which comprises:

means for holding a substantially stoichiometric solution;

means in fluid communication with said holding means for spraying said solution; and

means for receiving said sprayed solution to evaporate said solution and form a precipitate.

2. An apparatus according to Claim 1 comprising means associated with said evaporating means for removing said precipitate from said evaporating means.

3. An apparatus according to Claim 2 wherein said removing means comprises a scraper.

4. An apparatus according to Claim 3 wherein said scraper is made of teflon or steel.

5. An apparatus according to Claim 2, 3 or 4 wherein said evaporating means is a plate heatable to a predetermined temperature.

6. An apparatus according to Claim 5 wherein said plate is made of a glass ceramic.

7. An apparatus according to Claim 5 or 6 wherein said plate is formed with a smooth surface for receiving said sprayed solution.

8. An apparatus according to Claim 5, 6 or 7 comprising a base for holding said plate.

9. An apparatus according to Claim 8 comprising means for rotating said plate on said base and relative to said removing means to remove said precipitate from said plate.

10. An apparatus according to any of Claims 2 to 9 comprising means for calcining said precipitate.

11. An apparatus according to Claim 10 when dependent upon Claim 8 or 9 comprising means connected with said base for transporting said removed precipitate to said calcining means.

12. An apparatus according to Claim 10 or 11 wherein sand calcining means is a furnace or a rotary calciner.

13. An apparatus according to any of Claims 2 to 12 comprising means for grinding said removed precipitate.

14. An apparatus according to any preceding claim wherein said spraying means is a nozzle.

15. An apparatus according to Claim 14 wherein said nozzle is an atomiser or an ultrasonic nozzle.

16. An apparatus according to Claim 14 or 15 wherein said nozzle is made of titanium or glass.

17. An apparatus according to any preceding claim wherein said solution is a nitric acid solution containing a rare earth element or yttrium and copper and barium.

18. An apparatus according to Claim 17 wherein said rare earth element is dysprosium.

19. A method for preparing particles of superconductor material which comprises the steps of:

preparing a substantially stoichiometric nitric acid solution;

spraying said solution onto the smooth surface of a plate;

solution sprayed thereon, and to form a precipitate thereof;

removing said precipitate from said plate;

partially decomposing residual nitrates in said precipitate; and

calcining said precipitate.

20. A method according to Claim 19 further comprising the steps of:

grinding said precipitate after said calcining step; and

recalcining said precipitate.

21. A method according to Claim 19 or 20 further comprising the step of oxygenating said calcined precipitate.

22. A method according to Claim 21 wherein said oxygenating step is accomplished by slowly cooling said precipitate to an intermediate temperature of approximately four hundred degrees centigrade ($400^\circ$ C), maintaining said intermediate temperature for approximately four (4) hours and then slowly cooling said precipitate to room temperature.

23. A method according to Claim 21 or 22 wherein said oxygenating step is accomplished in an ozonated environment.

24. A method according to Claim 21 or 22 wherein said oxygenating step is accomplished in a carbon dioxide, water and hydrocarbon free environment.

25. A method according to any of Claims 19 to 24 wherein said solution is prepared by dissolving $Dy_2O_3$, $CuO$ and $Ba(NO_3)_2$ in nitric acid.

26. A method according to any of Claims 19 to 25 wherein said surface of said plate is preheated to the range between approximately one hundred eighty degrees centigrade and two hundred thirty degrees centigrade ($180^\circ$ C - $230^\circ$ C).

27. A method according to any of Claims 19 to 26 wherein said step of partially decomposing nitrates is accomplished by elevating the temperature of the removed precipitate to the temperature range between four hundred and six hundred degrees centigrade ($400^\circ$ C - $600^\circ$ C).

28. A method according to any of claims 19 to 27 wherein said spraying step is accomplished by forming solution droplets which are approximately ten to one hundred (10 -100) microns in diameter.

29. A method according to any of Claims 19 to 28 wherein said calcining step is accomplished by heating said precipitate to a temperature in the range of eight hundred degrees centigrade to nine hundred twenty-five degrees centigrade ($800^\circ$ C - $925^\circ$ C).

30. A method according to Claim 29 wherein said temperature is maintained for approximately one (1) hour to approximately eight (8) hours.

31. A method according to any of Claims 19 to 30 wherein the step of calcining said precipitate is accomplished in a carbon dioxide, water and hydrocarbon free environment.

32. A method according to any of Claims 19 to 31 wherein the step of calcining said precipitate is accomplished in an ozonated environment.

Fig. 1

Fig. 2